# EUROPÄISCHE PATENTSCHRIFT

(11) **EP 2 238 626 B1**
(45) Veröffentlichungstag und Bekanntmachung des Hinweises auf die Patenterteilung: **22.02.2012**
(21) Anmeldenummer: 08861948.1
(22) Anmeldetag: 10.12.2008
(51) Int. Cl.: H01L 31/18

(54) **VERFAHREN ZUR HERSTELLUNG EINES EINE ZWEIFACH-PUFFERSCHICHT AUFWEISENDEN HETEROKONTAKTES**
METHOD FOR PRODUCING HETEROCONTACT HAVING DOUBLE BUFFER LAYER
PROCÉDÉ DE FABRICATION D'UN HÉTÉROCONTACT PRÉSENTANT UNE DOUBLE COUCHE TAMPON

(30) Priorität: 14.12.2007 DE 102007060236
(43) Veröffentlichungstag der Anmeldung: 13.10.2010
(73) Patentinhaber: Helmholtz-Zentrum Berlin für Materialien und Energie GmbH, 14109 Berlin (DE)
(72) Erfinder: ANDRES, Stefan, CH-8810 Horgen (CH); LEHMANN, Carsten, 14169 Berlin (DE); PETTENKOFER, Christian, 14165 Berlin (DE)
(86) Internationale Anmeldenummer: PCT/DE2008/002080
(87) Internationale Veröffentlichungsnummer: WO 2009/076940

(56) Entgegenhaltungen:
- US-A1- 2006 180 200
- TERASAKO ET AL: "Properties of ZnO epitaxial layers and polycrystalline films prepared by metalorganic molecular beam epitaxial apparatus using diethylzinc and water as precursors" JOURNAL OF CRYSTAL GROWTH, ELSEVIER, AMSTERDAM, NL LNKD- DOI:10.1016/J.JCRYSGRO.2006.10.063, Bd. 298, 13. Februar 2007 (2007-02-13), Seiten 481-485, XP005864070 ISSN: 0022-0248
- LUTH H: "Chemical beam epitaxy-a child of surface science" SURFACE SCIENCE NETHERLANDS, Bd. 299-300, Nr. 1-3, 1. Januar 1994 (1994-01-01), Seiten 867-877, XP002583861 ISSN: 0039-6028
- YAMAGUCHI M ET AL: "Chemical beam epitaxy as a breakthrough technology for photovoltaic solar energy applications" JOURNAL OF CRYSTAL GROWTH, ELSEVIER, AMSTERDAM, NL LNKD- DOI:10.1016/0022-0248(94)90379-4, Bd. 136, Nr. 1-4, 1. März 1994 (1994-03-01), Seiten 29-36, XP024473870 ISSN: 0022-0248 [gefunden am 1994-03-01]

## Beschreibung

Die Erfindung betrifft ein Verfahren zur Herstellung eines eine Zweifach-Pufferschicht aufweisenden Heterokontaktes zwischen einer aktiven chalkogenidbasierten Halbleiterschicht und einer ZnO-Fensterkontaktschicht.

In Halbleiterbauelementen auf Heterokontaktbasis (z. B. Solarzelle) wird die Performance/Effizienz wesentlich durch die Bandanpassung an der Grenzfläche der verwendeten Materialien bestimmt. Im Fall von Dünnschichtsolarzellen auf Chalkopyritbasis besteht der Heterokontakt zwischen dem Chalkopyrit (CuInS₂, CuInSe₂) als Absorbermaterial und Zinkoxid als transparenter Frontelektrode.

Um effiziente Dünnschichtsolarzellen auf Chalkopyritbasis herzustellen, ist nach dem aktuellen Stand der Technik eine Cadmiumsulfid (CdS)-Pufferschicht an der Grenzfläche notwendig (s. beispielsweise in "Minimodules from a CuInS2 baseline process"; Thin Solid Films; 431-432 (2003) 534-537 oder in "Solar cells based on CuInS2 - an overview"; Thin Solid Films; 480-481 (2005) 509-514).

Diese Pufferschicht verbessert zwar die Bandanpassung des Heterokontaktes, führt aber zu folgenden technologischen Problemen:
- Die Verwendung von Cadmium als Schwermetall stellt aufgrund seiner hohen Toxizität ein hohes Risiko dar.
- Sowohl der Absorber, als auch die ZnO-Schichten werden über Vakuummethoden in-situ präpariert. Die CdS-Pufferschicht oder auch andere Puffer werden jedoch ausschließlich durch nasschemische Badabscheidung präpariert. Dadurch wird ein durchgängiger Inline-Prozess zur *in-situ* Herstellung der Dünnschichtsolarzellen verhindert.

Darüber hinaus führt das Wachstum des Chalkopyritabsorbers meist zu einer metallischen Kupfersulfidphase (CuS) an der Oberfläche. Auch diese Fremdphase wird in heute angewendeten Verfahren nasschemisch entfernt.

In letzter Zeit wurden Anstrengungen unternommen, die Anwendung von Zinkverbindungen auch auf Pufferschichten für CIS-Solarzellen auszudehnen und somit Cd-frei zu arbeiten. So wird in J. Appl. Phys. 99, 123503 (2006) über eine Zweifach-Pufferschicht aus ZnS/Zn(S,O) auf dem Absorber einer CuInS₂-Dünnschichtsolarzelle berichtet, die mittels chemischer Badabscheidung hergestellt wird. Dabei wird in einem ersten Stadium dieses Verfahrens eine dünne ZnS-Schicht auf der CIS-Absorberschicht abgeschieden. Im zweiten Stadium der Badabscheidung wird die Abscheidungsrate wesentlich erhöht, was zum Entstehen einer nicht phasenreinen Zn(S,O)-Schicht führt.

In Chem. Phys. Lett. 433 (2006) 71-74 wird ausgeführt, dass ein hoher Wirkungsgrad einer CuInS₂-Dünnschichtsolarzelle mit der oben erwähnten und durch chemische Badabscheidung hergestellten Zweifach-Pufferschicht aus ZnS/Zn(S,O) nur durch eine Temperatur-Nachbehandlung erreicht wird, die aber keine wesentlichen Änderungen in der Zweifach-Pufferschicht hervorruft.

Bei den beiden letztgenannten nasschemischen Verfahren ist ebenfalls eine industrielle Inline-Integration nicht möglich.

Aus US 4,612,411 ist eine Dünnschichtsolarzelle bekannt, bei der auf eine CIS-Schicht mittels CVD bzw. LTCVD eine hochohmige ZnO-Pufferschicht und darauf eine niederohmige ZnO-Fensterschicht aufgebracht wird. Das beschriebene Verfahren ermöglicht zwar eine Inline-Integration in einen industriellen Herstellungsprozess von CIS-Solarzellen, die Erzeugung einer Zweifach-Pufferschicht ist hier nicht beschrieben.

In US 2006/0180200 A1 ist nun eine Zweifachpufferschicht beschrieben, bei der auf einer CIGS-Schicht zunächst eine erste Zn(O,S)-Pufferschicht und darauf - in einem zweiten Abscheideschritt - eine zweite Pufferschicht, nämlich eine ZnO-Schicht, angeordnet ist. Beide Pufferschichten werden nacheinander mittels Atomic Layer Deposition (ALD) abgeschieden, wobei die Zn(Oₓ,S₁₋ₓ)-Pufferschicht, mit x zwischen 0 und 0,9, durch einen Übergang in die ZnO-Schicht überführt wird. Das ALD-Verfahren ist wegen der notwendigen regelmäßigen Reinigung der Kammer mittels Stickstoffpulsen zeitlich und technisch aufwändig.

Weiterhin ist bekannt und wird bespielsweise in Forschungsverbund Sonnenenergie, Workshop 2005, S. 25-27 und im Annual Report 2005, Hahn-Meitner-Institut Berlin GmbH, S. 92-93 beschrieben, Zinkoxid mittels MOMBE (metal organic molecular beam epitaxie) auf Al₂O₃ oder ZnO oder SiC aufzubringen, um die elektronische Struktur derartig aufgewachsener ZnO-Schichten zu untersuchen.

Aufgabe der Erfindung ist es nun, ein weiteres Verfahren zur Herstellung eines eine Zweifach-Pufferschicht aufweisenden Heterokontaktes zwischen einer aktiven chalkogenidbasierten Halbleiterschicht und einer ZnO-Fensterkontaktschicht anzugeben, das keine nasschemischen Prozessschritte enthält und sich insbesondere in einen Inline-Herstellungsprozess für CIS-Dünnschichtsolarzellen einpasst, dabei ohne die Verwendung von CdS für die Pufferschicht auskommt, und schneller und mit weniger Aufwand durchzuführen ist als bisher dem Stand der Technik nach bekannte Verfahren. Das Verfahren soll dabei eine optimale Bandanpassung der Schichten des Heterokontaktes je nach Anwendungszweck ermöglichen.

Die Aufgabe wird erfindungsgemäß durch ein Verfahren mit den Merkmalen des Anspruchs 1 gelöst.

Die erfindungsgemäße Lösung sieht vor, mittels eines MOMBE-Verfahrens einen direkten Heterokontakt zwischen einer chalkogenidbasierten Halbleiterschicht und einer ZnO-Fensterkontaktschicht herzustellen, wobei sich überraschenderweise gezeigt hat, dass sich intrinsisch eine sehr dünne ZnX-Pufferschicht mit X = S, Se, Te zwischen der Halbleiterschicht und der zweiten phasenreinen Teilpufferschicht aus ZnO bildet, deren Ausbildung keinen weiteren Verfahrensschritt - wie im Stand der Technik beschrieben - erforderlich macht. Die ZnO-Fensterkontaktschicht wird dann mit üblichen, dem Stand der Technik nach bekannten Mitteln auf die zwei phasenreine Teilschichten aufweisende Pufferschicht aufgebracht.

Im Falle einer CuInS₂-Absorberschicht verdrängt die sich selbstausbildende Zinksulfid (ZnS)-Pufferschicht an der Grenzfläche eventuell vorhandenes überschüssiges Kupfersulfid (CuS) von der Oberfläche, so dass ein nasschemischer Präparationsschritt zur Entfernung von CuS entfällt. Auch für andere chalkogenidbasierte Halbleitermaterialien wird eine solche Wirkung der Zn-Chalkogen-Schicht erwartet.

Die Verwendung von CdS als Pufferschicht ist bei dem erfindungsgemäßen Verfahren nicht notwendig.

In Ausführungsformen der Erfindung ist vorgesehen, als aktive chalkogenidbasierte Halbleiterschicht eine I-III-VI-Halbleiterschicht mit Chalkopyritstruktur, insbesondere eine schwefelhaltige - und hierfür eine CuInS₂-Schicht, zu verwenden.

In einer anderen Ausführungsform ist vorgesehen, als Precursormaterialien Diethylzink und Wasser zu verwenden. Der Druck der gasförmigen Precursormaterialien wird kleiner 10⁻⁴ mbar eingestellt.

Mit dem Verfahrensschritt des Abscheidens im erfindungsgemäßen Verfahren mittels MOMBE, bei dem die Precursormaterialien unter Beibehaltung der eingestellten Temperatur und des eingestellten Druckes auf die Oberfläche der Halbleiterschicht in Abhängigkeit der Wachstumsrate abgeschieden werden, wird sowohl eine phasenreine Teilpufferschicht aus ZnO - wie erwartet - gebildet, aber zunächst auf der Halbleiterschicht - wie sich überraschenderweise zeigte - eine intrinsisch ausgebildete, sehr dünne ZnX-Pufferschicht mit X = S, Se, Te zwischen der Halbleiterschicht und der zweiten phasenreinen Teilschicht, der ZnO-Schicht. Diese zwischenliegende ZnX-Schicht mit X = S, Se, Te ist dadurch charakterisiert, dass sie keinen Sauerstoff enthält. Damit weist der Heterokontakt eine Pufferschicht aus zwei phasenreinen Teilschichten auf, die eine verbesserte Bandanpassung ermöglicht.

Die Erfindung soll im folgenden Ausführungsbeispiel anhand von Zeichnungen näher beschrieben werden.

Dabei zeigen
- Fig. 1:: eine schematische Darstellung der Wachstumskinetik der Zweifach-Pufferschicht für MOMBE;
- Fig. 2:: eine schematische Darstellung der Struktur des mit dem erfindungsgemäßen Verfahren hergestellten Heterokontaktes;
- Fig. 3:: das Banddiagramm des Heterokontaktes gemäß Fig. 2.

Das für die Herstellung eines eine mindestens ZnO enthaltende Pufferschicht aus zwei phasenreinen Teilschichten aufweisenden Heterokontaktes eingesetzte MOMBE-Verfahren stellt - wie bekannt - eine Hybridtechnik aus herkömmlicher Molekularstrahlepitaxie (MBE) und chemischer Gasphasenabscheidung (CVD) dar. MOMBE vereint dabei die Vorteile beider Abscheidetechniken. Zum einen erlaubt der gerichtete Strahl der Quellen die Präparation von abrupten Halbleiterheterokontakten mit einer Genauigkeit im Monolagenbereich. Zum anderen erlaubt die Verwendung gasförmiger Ausgangsstoffe eine präzise Kontrolle des Materialflusses und eine einfache Skalierung des Prozesses auf großflächige Anwendungen.

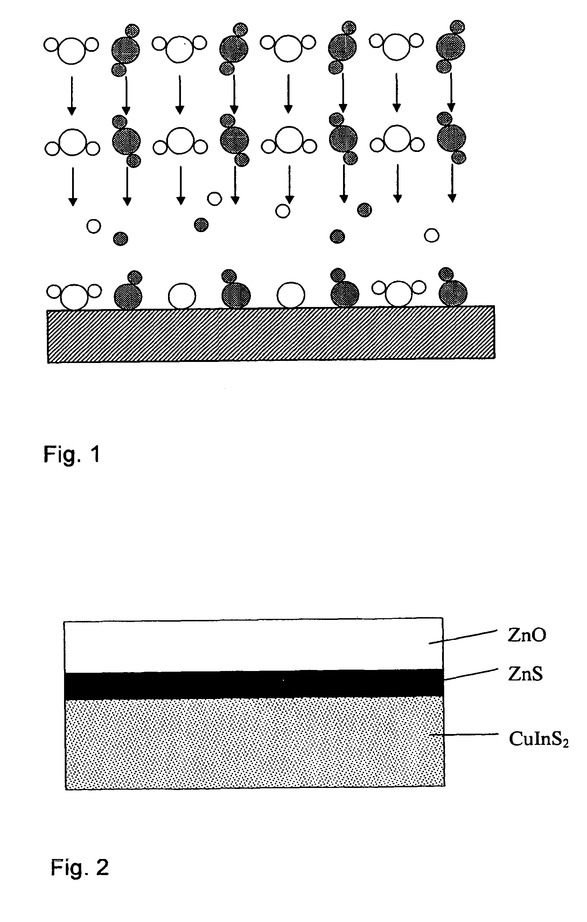

Die Precursoren für den MOMBE-Prozess, im Ausführungsbeispiel Diethylzink Zn(C₂H₅)₂ und Wasser H₂O, werden im gasförmigen Zustand in die Wachstumskammer eingelassen. Dosiert man den Druck dabei so, dass er zu keinem Zeitpunkt höher als 10⁻⁴mbar ist, bleibt die mittlere freie Weglänge λ der Moleküle größer als der Abstand zwischen Einlass und Substrat. Die Quellen können daher als gerichtete Molekülstrahlen aufgefasst werden. An der geheizten Substratoberfläche, beispielsweise einer CuInS₂-Oberfläche, zersetzen sich die Precursoren pyrolytisch und reagieren miteinander. Dies ist schematisch in Figur 1 gezeigt.

Prinzipiell ist das Verfahren jedoch nicht auf die genannten Precursoren beschränkt. Auch andere zink- und sauerstoffhaltige Precursoren, die einen geeigneten Dampfdruck besitzen und miteinander zu Zinkoxid reagieren, können eingesetzt werden.

Das konkrete Ausführungsbeispiel für die Herstellung einer Pufferschicht aufweisend zwei phasenreine Teilschichten eines Heterokontaktes für eine CuInS₂-Schicht und eine ZnO-Fensterschicht umfasst die in UHV-Kammern ablaufenden Verfahrensschritte
- Präparation des CuInS₂-Substrates wie in "Epitaxial CuInS2 on Si(111) using di-tert-butyl disulfide as sulphur precursor"; Thin Solid Films; 480-481; 347-351 beschrieben;
- Einschleusen des CuInS₂-Substrates in die MOMBE-Kammer;
- 10 min Aufwärmen des Substrates auf 450°C;
- Einregeln des Diethylzinkdrucks auf p_{DEZ} = 2*10⁻⁶ mbar;
- Einregeln des Wasserdrucks auf p_{H2O} = 8*10⁻⁶mbar;
- Start der Abscheidung durch Rotation des Manipulators in die den Precursorquellen zugewandte Richtung;
- Abscheidung bei definierter Depositionszeit und einer Substrattemperatur von T_{S} = 450°C;
- Beendigung der Abscheidung durch Rotation des Manipulators in die von den Precursorquellen abgewandte Richtung;
- Schließen der Precursorquellen;
- Ausschleusen der Probe mit der erzeugten Heterostuktur.

Da die UHV-Kammern, in denen das Verfahren abläuft, mittels Transfersystem miteinander verbunden sind, können atmosphärische Verunreinigungen ausgeschlossen werden.

Insgesamt wurden zehn Depositionsschritte durchgeführt, wobei die Dauer des kürzesten Schrittes 5 s und die des längsten Schrittes 30 min betrug. Nachdem im Photoelektronenspektrum keine Substratemission mehr beobachtet werden konnte, wurden keine weiteren Depositionsschritte durchgeführt.

Das Ergebnis dieses Prozesses ist schematisch in Fig. 2 dargestellt und zeigt eine CuInS₂-Schicht mit aufgebrachter aus zwei - phasenreinen Teilschichten bestehenden Pufferschicht aus sehr dünner ZnS-Schicht und ZnO-Schicht, auf der dann im weiteren Bauelementeaufbau eine ZnO-Fensterschicht aufgebracht wird.

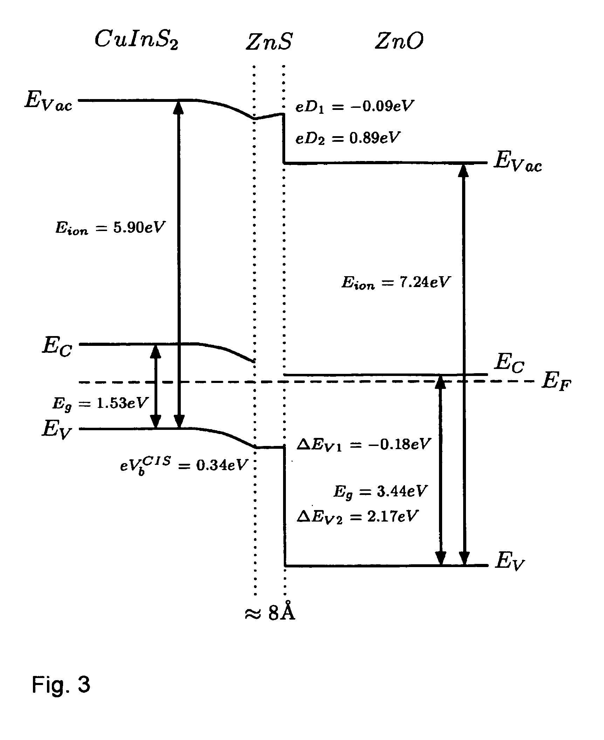

Das zugehörige Banddiagramm ist in Fig. 3 dargestellt. Die durch Photoelektronenspektroskopie bestimmte Bandanpassung der in Fig. 2 schematisch gezeigten Struktur zeigt einen optimalen Übergang im Leitungsband ohne Versatz an der Grenzfläche.

Wie bereits erwähnt, ermöglicht das erfindungsgemäße Verfahren einen Inline-Prozess zur Herstellung von Dünnschichtsolarzellen auf Chalkopyritbasis, bei dem die Verwendung toxischen Cadmiums entfallen kann.

## Patentansprüche

1. Verfahren zur Herstellung eines eine Zweifach-Pufferschicht aufweisenden Heterokontaktes zwischen einer aktiven chalkogenidbasierten Halbleiterschicht und einer Fensterkontaktschicht, **dadurch gekennzeichnet, dass**
- die aktive chalkogenidbasierte Halbleiterschicht in eine MOMBE-Kammer eingeschleust wird,
- danach die Halbleiterschicht auf eine Temperatur zwischen 200 °C und 550 °C eingestellt wird,
- gasförmige zink- und sauerstoffhaltige Precursormaterialien verwendet werden, deren Druck kleiner 10-4 mbar eingestellt wird, wobei die Reaktion der Precursormoleküle nur an der Oberfläche der Halbleiterschicht erfolgt,
- anschließend die Precursormaterialien unter Beibehaltung der eingestellten Temperatur und des eingestellten Druckes auf die Oberfläche der Halbleiterschicht in bis zu 10 Depositionsschritten mit einer jeweiligen Depositionsdauer zwischen 5 s und 30 min abgeschieden werden,
- dann die Zufuhr der Precursormaterialien beendet wird, wenn im Photoelektronenstromspektrum keine Substratemission mehr beobachtet wird und
- letztendlich die aktive chalkogenidbasierte Halbleiterschicht mit der entstehenden Pufferschicht ausgeschleust wird, wobei die entstehende Pufferschicht zwei phasenreine Teilschichten aufweist, nämlich eine ZnO-Schicht und eine intrinsisch entstehende ZnX-Schicht, wobei X bedeutet S oder Se oder Te.

2. Verfahren nach Anspruch 1,
**dadurch gekennzeichnet, dass**
als aktive chalkogenidbasierte Halbleiterschicht eine I-III-VI-Halbleiterschicht mit Chalkopyritstruktur verwendet wird.

3. Verfahren nach Anspruch 2,
**dadurch gekennzeichnet, dass**
eine schwefelhaltige I-III-VI-Halbleiterschicht mit Chalkopyritstruktur verwendet wird.

4. Verfahren nach Anspruch 3,
**dadurch gekennzeichnet, dass**
eine CuInS₂-Schicht verwendet wird.

5. Verfahren nach Anspruch 1,
**dadurch gekennzeichnet, dass**
als Precursormaterialien Diethylzink und Wasser verwendet werden.

## Claims

1. A method for producing a heterocontact having a double buffer layer between an active chalcogenide-based semiconductor layer and a window compact layer,
**characterized in that**
- the active chalcogenide-based semiconductor layer is introduced into an MOMBE chamber,
- then the semiconductor layer is set at a temperature between 200°C and 550°C,
- gaseous precursor materials containing zinc and oxygen are used, their pressure being set at less than 10⁻⁴, mbar wherein the reaction of the precursor molecules occurs only at the surface of the semiconductor layer,
- then the precursor materials are deposited on the surface of the semiconductor layer in up to 10 deposition steps, with a respective deposition interval between 5 s and 30 min for each step while retaining the set temperature and the set pressure,
- then the supply of the precursor materials is terminated when no substrate emission is being observed any longer in the photoelectron current spectrum and
- ultimately the active chalcogenide-based semiconductor layer having the resulting buffer layer is removed, such that the resulting buffer layer has two pure-phase partial layers, namely a ZnO layer and an intrinsically formed ZnX layer, where X denotes S or Se or Te.

2. The method according to Claim 1,
**characterized in that**
a I-III-VI semiconductor layer having a chalcopyrite structure is used as the active chalcogenide-based semiconductor layer.

3. The method according to Claim 2,
**characterized in that**
a sulfur-containing I-III-VI semiconductor layer having a chalcopyrite structure is used.

4. The method according to Claim 3,
**characterized in that**
a CuInS₂ layer is used.

5. The method according to Claim 1,
**characterized in that**
diethyl zinc and water are used as precursor materials.

## Revendications

1. Procédé de fabrication d'un hétérocontact comportant une double couche tampon entre une couche de semi-conducteurs active à base de chalcogénures et une couche fenêtre de contact, **caractérisé en ce**
- **qu'**on introduit la couche de semi-conducteurs à base de chalcogénures dans une chambre MOMBE,
- on règle ensuite la couche de semi-conducteurs à une température comprise entre 200 °C et 550 °C,
- on utilise des matériaux précurseurs gazeux contenant du zinc et de l'oxygène, dont la pression est inférieure à 10⁻⁴ mbar, la réaction des précurseurs moléculaires ne s'effectuant que sur la surface de la couche de semi-conducteurs,
- on dépose ensuite les matériaux précurseurs en maintenant la température réglée et la pression réglée sur la surface de la couche de semi-conducteurs en jusqu'à 10 étapes de déposition, avec une durée de déposition respective comprise entre 5 secondes et 30 mn,
- on met fin ensuite à l'apport de matériaux précurseurs lorsqu'il n'est plus observé aucune émission du substrat dans le spectre du flux de photoélectrons et
- pour finir, on évacue la couche de semi-conducteurs à base de chalcogénures avec la couche tampon naissante, la couche tampon naissante comportant deux couches partielles exemptes d'impuretés de phase, à savoir une couche ZnO et une couche ZnX se produisant de façon intrinsèque, X signifiant S ou Se ou Te.

2. Procédé selon la revendication 1,
**caractérisé en ce**
**qu'**on utilise en tant que couche de semi-conducteurs à base de chalcogénures une couche de semi-conducteurs I-III-VI à structure chalcopyrite.

3. Procédé selon la revendication 2,
**caractérisé en ce**
**qu'**on utilise une couche de semi-conducteurs I-III-VI sulfureuse à structure chalcopyrite.

4. Procédé selon la revendication 3,
**caractérisé en ce**
**qu'**on utilise une couche de CulnS₂.

5. Procédé selon la revendication 1,
**caractérisé en ce**
**qu'**on utilise en tant que matériaux précurseurs du diéthylzinc et de l'eau.
